(19) Europäisches Patentamt
European Patent Office
Office européen des brevets

(11) **EP 3 309 560 B1**

(12) **EUROPÄISCHE PATENTSCHRIFT**

(45) Veröffentlichungstag und Bekanntmachung des Hinweises auf die Patenterteilung:
**25.03.2020  Patentblatt 2020/13**

(51) Int Cl.:
***G01R 22/00*** *(2006.01)*   ***G01D 4/00*** *(2006.01)*

(21) Anmeldenummer: **17186233.7**

(22) Anmeldetag: **15.08.2017**

(54) **VERFAHREN ZUM ERFASSEN DES ENERGIEVERBRAUCHES EINES ELEKTRISCHEN VERBRAUCHERS**

METHOD OF DETECTING THE ENERGY CONSUMPTION OF AN ELECTRIC LOAD

PROCÉDÉ DE DÉTERMINATION DE CONSOMMATION D'ÉNERGIE ÉLECTRIQUE D'UN CONSOMMATEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.10.2016  DE 102016119277**

(43) Veröffentlichungstag der Anmeldung:
**18.04.2018  Patentblatt 2018/16**

(73) Patentinhaber: **Insta GmbH**
**58509 Lüdenscheid (DE)**

(72) Erfinder:
• **Groll, Roland**
**58507 Lüdenscheid (DE)**
• **Detzner, Peter**
**58089 Hagen (DE)**
• **Krause, Karl-Heinz**
**58809 Neuenrade (DE)**
• **Marks, Pierre**
**58453 Witten (DE)**

(56) Entgegenhaltungen:
**US-A1- 2011 153 246     US-A1- 2014 081 474
US-A1- 2015 058 276**

EP 3 309 560 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## Beschreibung

Die Erfindung betrifft ein Verfahren zum Erfassen des Energieverbrauches eines über einen Phasenan- oder Phasenabschnittsdimmer angesteuerten elektrischen Verbrauchers.

Es gibt zahlreiche Anwendungen, bei denen elektrische Verbraucher, typischerweise Leuchten gedimmt werden. Dieses erfolgt in aller Regel über einen Phasenan- oder Phasenabschnittsdimmer. Bei diesem Konzept erhält die anzusteuernde Leuchte nur einen bestimmten Anteil einer Halbwelle, und zwar einen solchen Anteil, der dem gewünschten Dimmwert entspricht. In vielen Fällen wird bei elektrischen Verbrauchern eine Erfassung des Energieverbrauches gewünscht. Dieses trifft auch für elek-trische Verbraucher zu, die über einen Phasenan- oder Phasenabschnittsdimmer angesteuert werden. Zum Realisieren einer solchen Energieverbrauchserfassung werden zusätzliche Bauteile, Schaltungsanordnungen oder dergleichen benötigt. Dieses verursacht in vielen Fällen einen nennenswerten Mehraufwand, der sich auch in den Kosten, die ein Nutzer einer solchen Energieverbrauchserfassung aufwenden muss, niederschlägt. Im Falle von über einen Dimmer angesteuerten Leuchten werden eine der Dimmeranzahl entsprechende Anzahl solcher Energieverbrauchserfassungsgeräte benötigt. Typischerweise befinden sich in einem Gebäude eine Mehr- oder auch Vielzahl an Räumen, die insbesondere auch unterschiedlich gedimmt sein können.

US 2014/0081474 A1 beschreibt ein Verfahren zur Ermittlung des Energieverbrauchs einer Last in einem zwei-adrig ausgelegten Phasenanschnitts- oder -abschnittsdimmers anhand der realen, zeitaufgelösten Werte für Spannung und Strom. Problematisiert wird hier das Ermitteln des zeitaufgelösten Spannungswertes während der Leitend-Phase des Dimmers. Gelöst wird dies durch das Extrapolieren des Spannungsverlaufs mithilfe eines Signalgenerators.

US 2011/0153246 A1 offenbart ein Verfahren zur Ermittlung des Energieverbrauchs einer Last ebenfalls mittels zeitaufgelöster Werte für Spannung und Strom. Beschrieben wird insbesondere der spezielle Aufbau einer Detektierungsvorrichtung, die für mehrere Ausgänge erkennt, welche Art des Energieverbrauchs an denselben vorliegt. Hierzu wird beispielsweise der Phasenunterschied zwischen Spannung und Strom ausgewertet.

Vor diesem Hintergrund liegt der Erfindung die Aufgabe zugrunde, ein Verfahren zum Erfassen des Energieverbrauches einer über einen Phasenan- oder Phasenabschnittsdimmer angesteuerten elektrischen Last, beispielsweise einer Leuchte oder Leuchtenanordnung, vorzuschlagen, mit dem eine Energieverbrauchserfassung in einfacher und kostengünstiger Art und Weise möglich ist.

Gelöst wird diese Aufgabe erfindungsgemäß durch ein eingangs genanntes gattungsgemäßes Verfahren mit den Merkmalen des Anspruchs 1.

Bei diesem Verfahren wird der Energieverbrauch unter Zugrundelegung des Stromflusses innerhalb einer den elektrischen Verbraucher beaufschlagenden Sinushalbwelle ermittelt. Die einen elektrischen Verbraucher beaufschlagende Sinushalbwelle gibt genügend Informationen, um daraus den Energieverbrauch mit hinreichender Genauigkeit zu erfassen. Dieses Konzept erlaubt es, dass die Energieverbrauchserfassung in dem Dimmer beziehungsweise mit den zum Dimmen vorgesehenen Bauteilen erfolgt. Somit wird die Energieverbrauchserfassung an derjenigen Stelle im System durchgeführt, an der der elektrische Verbraucher als Last, also beispielsweise die Leuchte oder die Leuchtenanordnung, hinsichtlich des Dimmwertes angesteuert wird. Da dieses mit einem Phasenan- oder Phasenabschnittsdimmer erfolgt, ist dimmerseitig bekannt, welcher Anteil einer Sinushalbwelle dem elektrischen Verbraucher für seine Bestromung zugeführt wird. Dieses entspricht schließlich dem eingestellten Dimmwert. Diese Information über den Stromfluss wird einem Anwender entweder angezeigt und/oder abrufbar gespeichert. Dieses wiederum muss nicht notwendigerweise in dem Dimmer selbst erfolgen, vielmehr können diese Daten an eine bezüglich des Dimmers externe Auswerteeinheit übertragen werden. Eine Übertragung der Daten kann beispielsweise im Rahmen eines Gebäudeinstallationsbusses, an den der Dimmer und die Auswerteeinheit angeschlossen sind. Bei einer solchen Auswerteeinheit kann es sich beispielsweise um eine mobile Bedieneinrichtung handeln, mit der die Leuchten in einem Gebäude oder auch andere Gebäudeinstallationen angesteuert werden können. Bei einer solchen Bedieneinrichtung kann es sich um einen mobilen Computer, beispielsweise in Form eines Smartphones, eines Tablets oder dergleichen handeln, auf dem eine entsprechende Anwendung installiert ist.

In einer ersten Ausgestaltung der Energieverbrauchserfassung wird die tatsächlich verbrauchte Energie unter Zugrundelegung des Anteils der Sinushalbwelle, mit der der elektrische Verbraucher angesteuert wird, und der Lasthöhe des elektrischen Verbrauchers ermittelt. Bei dem Sinushalbwellenanteil kann es sich auch um die gesamte Sinushalbwelle handeln. Die Lasthöhe des Verbrauchers ist auswerteseitig bekannt, also beispielsweise auf einem mobilen Bediengerät hinterlegt. Hieraus kann, wenn der Anteil der Sinushalbwelle bekannt ist, mit der der elektrische Verbraucher bestromt wird, der Energieverbrauch berechnet werden. Bei dieser Ausgestaltung braucht von dem Dimmer nur der Dimmwert, der einem bestimmten Anteil einer Sinushalbwelle entspricht, an die Auswerteeinheit übermittelt zu werden. Eine solche Energieverbrauchserfassung ist mit den in dem Dimmer ohnehin vorhandenen Ressourcen möglich und benötigt daher keinen Mehraufwand. Dennoch ist die Energieverbrauchserfassung für viele Anwendungsfälle hinreichend genau, um diesen zu genügen. Es versteht sich, dass bei einer solchen Energieverbrauchserfassung die Genauigkeit davon abhängt, in wie weit die zu dem Verbraucher angegebene Lasthöhe mit der tatsächlichen übereinstimmt. Die Unschärfe nimmt zu, wenn mit einem Dimmer mehrere elektrische Verbraucher, wie dieses typischerweise bei Leuchten beim Ansteuern von einer Vielzahl von einzelnen Lichtquellen der Fall ist, angesteuert werden. Dennoch ist, um eine grundsätzliche verlässliche Übersicht über den Energieverbrauch zu erfassen, auch diese Verfahrenausgestaltung sinnvoll einsetzbar, zumal sich diese, wie vorstehend bereits angedeutet, ohne nennenswerten Mehraufwand, wenn überhaupt, realisieren lässt. Bei der Auswertung können Lasthöhen charakteristische Änderungen, die sich über die Lebensdauer einstellen, berücksichtigt werden, wodurch die Verlässlichkeit einer Energieverbrauchserfassung auf diese Weise verbessert werden kann. Gleiches gilt für andere Einflüsse, die zu einer Lasthöhenänderung beitragen können.

Um die Datenübertragung von einem Dimmer an die Auswerteeinheit gering zu halten, ist in einer Verfahrensausgestaltung vorgesehen, dass nur jede Änderung des Dimmwertes der Auswerteeinheit übermittelt wird. Dieses ist sinnvoll, da innerhalb einer unveränderten Einstellung des Dimmwertes nicht von einer Änderung des Energieverbrauches auszugehen ist.

Erfindungsgemäß wird die Energieverbrauchserfassung mittels einer Strommessung an dem aktuell fließenden Strom über die Dimmerlogik vorgenommen, beispielsweise über einen dimmerseitig vorhandenen A/D-Wandler. Eine solche Strommessung ist mit der dimmerseitig vorhandenen Logik möglich, so dass auch für diese Energieverbrauchserfassung kein nennenswerter Mehraufwand betrieben werden muss. Eine solche Energieverbrauchserfassung wird man in vorgegebenen Zeitabständen vornehmen. Eine kontinuierliche Strommessung ist nicht erforderlich. Zur Kompensation von Schwankungen in dem gemessenen Stromfluss kann vorgesehen sein, die Strommessung in einer vorgegebenen Frequenz über eine vorgegebene Zeitspanne durchzuführen und aus den aufsummierten Ergebnissen den auf die Zeitspanne bezogenen Energieverbrauch zu ermitteln.

Vorteilhaft ist es, den dimmerseitig vorhandenen Spannungsteiler durch Anheben des Gleichspannungspegels für die Zwecke der Strommessung zu nutzen. Auf diese Weise können von einem mit positiver Betriebsspannung arbeitenden Mikrocontroller, was die Regel sein dürfte, positive und negative Ströme gemessen werden. Die Anhebung des Gleichspannungspegels ist vorzugsweise so zu wählen, dass im zu erwartenden Messbereich die positive Grenze und negative Grenze des Messeingangs des Mikrocontrollers nicht überschritten werden. Die anliegende Netzspannung kann als konstant angenommen werden. Wenn diesbezüglich eine genauere Energieerfassung vorgenommen werden soll, wird in einer Weiterbildung auch die aktuell anliegende Netzspannung ermittelt und der Auswerteeinrichtung mitgeteilt.

Zur Bestimmung des Halbwellenanteils, mit dem ein elektrischer Verbraucher durch den Dimmer angesteuert wird, kann eine Strommessung auch nur an einzelnen Punkten einer Halbwelle erfolgen. Diese einzelnen Punkte werden sodann zu einer Kurve verbunden, so dass auf diese Weise der Stromfluss der gesamten Halbwelle ermittelt werden kann. Auswerteseitig kann die aktuelle Energie einer Halbwelle gespeichert werden. Hierfür kann beispielsweise ein Kondensator eingesetzt werden. Nach der Halbwelle wird sodann die gespeicherte Energie, beispielsweise die in dem Kondensator gespeicherte Spannung, gemessen und mit der Nulllage verrechnet. Aus diesem Wert kann sodann unter Einbeziehung von Umrechnungsfaktoren der aktuelle Energieverbrauch ermittelt werden. Ist die in dem Kondensator gespeicherte Spannung gemessen, wird dieser entladen, damit er für die nächste Halbwellenmessung zur Verfügung steht.

Der Dimmer ist vorzugsweise über eine drahtlose Kommunikation in ein lokales Datennetzwerk eingebunden. Die für die Energieverbrauchserfassung notwendigen Daten werden sodann auf diesem Wege an die Auswerteeinrichtung übertragen.

Nachfolgend ist die Erfindung anhand eines Ausführungsbeispiels unter Bezugnahme auf die beigefügten Figuren beschrieben. Es zeigen:

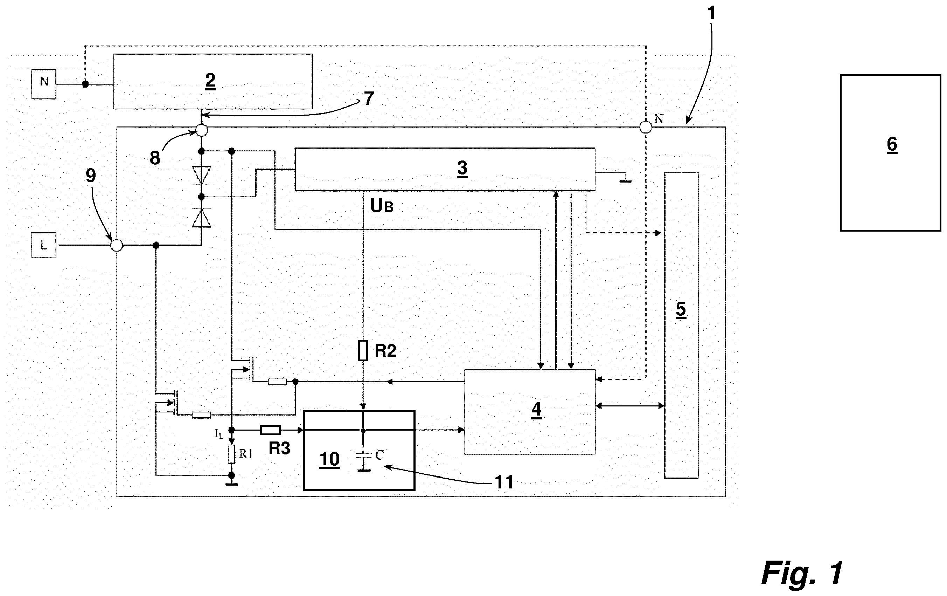

**Fig. 1:**   Ein Blockschaltdiagramm eines einen elektrischen Verbraucher ansteuernden Dimmers mit einem einen A/D-Wandler umfassenden Strommessmodul und

**Fig. 2:**   ein Diagramm zum Darstellen eines Vergleichs des berechneten Fehlers in einer Gegenüberstellung mit gemäß dem beanspruchten Verfahren ermittelten Fehler.

Ein als Phasenanschnittsdimmer ausgelegter Dimmer 1 dient zur Versorgung einer mehrere Lichtquellen umfassenden Leuchteneinheit 2. Der Dimmer 1 umfasst die üblichen Komponenten, wie beispielsweise eine Stromversorgung 3, eine Logik 4, die bei dem dargestellten Ausführungsbeispiel durch einen Mikrocontroller realisiert ist, und eine Schnittstelle 5, mit der der Dimmer 1 an eine Auswerte- und Ansteuereinheit 6 angeschlossen ist. Die Kommunikation zwischen dem Dimmer 1 und der Auswerte- und Ansteuereinheit 6 erfolgt bei dem dargestellten Ausführungsbeispiel über eine drahtlose Kommunikationsstrecke im Rahmen eines Gebäudeinstallationsbusses. Die Leuchteneinheit 2 ist mittels einer Lastleitung 7 an den Lastausgang 8 des Dimmers 1 angeschlossen. Der Lastausgang 8 erhält seine Phase über den an die Netzphase L angeschlossenen Phaseneingang 9. Über die Lastleitung 7 und die Leuchteneinheit 2 ist der Dimmer 1 an Masse N angeschlossen.

Zusätzlich zu den vorgenannten Komponenten verfügt der Dimmer 1 über eine Strommesseinrichtung 10. Diese ist in der Figur gesondert dargestellt, kann jedoch Teil der Logik 4 sein. Die Strommesseinrichtung 10 umfasst bei dem dargestellten Ausführungsbeispiel eine Kondensatorschaltung 11.

Die Strommesseinrichtung 10 ist über einen durch die Widerstände R2 und R3 gebildeten Spannungsteiler an die Stromversorgung 3 angeschlossen. Zum Ermitteln des Energieverbrauches durch die Leuchteneinheit 2 wird durch die Strommesseinrichtung 10 der aktuell fließende Strom ermittelt. Dieses erfolgt bei dem dargestellten Ausführungsbeispiel über den als Teil der Strommesseinrichtung 10 dienenden und ohnehin vorhandenen A/D-Wandler (nicht gesondert dargestellt). Dabei ist der durch die Widerstände R2, R3 bereitgestellte Spannungsteiler so eingerichtet, dass die zu messenden Ströme, die im Leistungsbereich des Dimmers zu erwarten sind, eine solche Spannungsänderung hervorrufen, dass diese innerhalb der Betriebsspannungsgrenzen bleiben. Da sowohl positive als auch negative Änderungen zu erwarten sind, erfolgt die Anhebung durch den Spannungsteiler vorzugsweise auf die halbe Betriebsspannung.

Die Energie einer Halbwelle wird in der Kondensatorschaltung 11 gespeichert. Die gemessene Spannung stellt somit das Integral des Wertes der Halbwelle für den Stromfluss dar und wird mit der Zeit der kompletten Halbwelle verrechnet. Insofern werden aus dem phasenangeschnittenen Signal die Werte für

$$\sqrt{\int i^2(t)\,dt}$$

und

$$\int i(t)\,dt$$

ermittelt und daraus der Abweichungsfehler berechnet:

$$Abweichung\ in\ \% = \frac{a - b}{a} \cdot 100$$

$$mit\ a = \sqrt{\int i^2(t)\,dt}\,, \qquad b = \int i(t)\,dt$$

Der Wert für b ist der über die Strommesseinrichtung 10 ermittelte Wert.

Infofern erhält man auf diese Weise eine Funktion in Abhängigkeit von dem Phasenwinkel - dem eingestellten Dimmwert.

Es ist nun in Abhängigkeit von dem elektrischen Verbraucher, hier: der Leuchteneinheit 2, eine Korrektur durchzuführen. Dieses erfolgt unter Einbeziehung von Umrechnungsfaktoren. Eine solche Korrektur braucht lediglich in dem relevanten Dimmbereich vorgenommen zu werden. Diese befindet sich typischerweise in dem Intervall zwischen 3 msec und 8 msec einer Halbwelle. Die Korrekturfunktion wird anhand folgender Formel durchgeführt:

$$\frac{\frac{b}{1 - \left(\frac{c}{100}\right)}}{\sqrt{2}}$$

mit b = $\int i(t)dt$, c = *Korrekturfaktor*(*Phasenwinkel*)

In besonderer Weise ergeben sich mit diesen, mit einfachen Mitteln zu erzielenden Daten Effektivwerte, die sich gemäß der nachstehenden Formel

$$I_{Effektivwert} = \frac{\sqrt{\int i^2(t)\,dt}}{\sqrt{2}}$$

ansonsten nur mit einem ressourcenstarken Mikrocontroller realisieren lassen. Ein solcher steht bei Dimmern jedoch nicht zur Verfügung und soll für die Zwecke einer Energieverbrauchserfassung auch nicht eingebaut werden. Mit den üblichen, in einem Dimmer zur Verfügung stehenden Ressourcen lassen sich hingegen die Effektivwerte ohne weiteres berechnen.

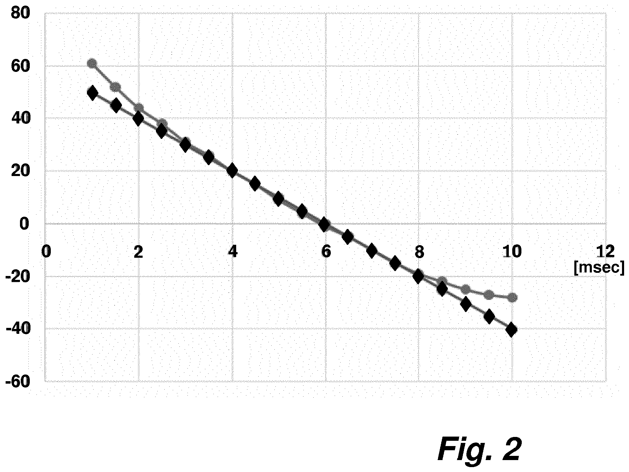

Figur 2 zeigt eine Gegenüberstellung der mit einem leistungsfähigen Mikrocontroller berechneten Effektivwerte gemäß der vorstehenden Formel (Kreissignatur) mit den im Rahmen der vorbeschriebenen Beschreibung der Erfindung ermittelten Effektivwerten (Rautensignatur). Diese Kurve zeigt, dass in dem relevanten Dimmbereich in dem Halbwelleninterval zwischen 3 msec und 8 msec beide Kurven quasi deckungsgleich sind. Aus diesem Grunde können die Effektivwerte der Fehler (y-Achse) auch für die durch das vorstehende Verfahren ermittelten Werte verwendet werden, die aus einer vorangegangenen aufwendigeren Berechnung ermittelt worden sind.

Die Erfindung ist anhand von Ausführungsbeispielen beschrieben worden. Ohne den Umfang der geltenden Ansprüche zu verlassen, ergeben sich für einen Fachmann zahlreiche weitere Ausgestaltungsmöglichkeiten, die Erfindung im Rahmen der geltenden Ansprüche umzusetzen.

## Patentansprüche

1. Verfahren zum Erfassen des Energieverbrauches eines über einen Phasenan- oder Phasenabschnittsdimmer (1) angesteuerten elektrischen Verbrauchers (2), **dadurch gekennzeichnet, dass** der aktuelle Energieverbrauch des elektrischen Verbrauchers (2) unter Zugrundelegung eines Effektivwertes des Stromflusses innerhalb einer den elektrischen Verbraucher (2) beaufschlagenden Sinushalbwelle ermittelt wird, indem in Abhängigkeit von dem elektrischen Verbraucher eine Korrekturfunktion anhand folgender Formel

$$\frac{\dfrac{b}{1-\left(\dfrac{c}{100}\right)}}{\sqrt{2}}$$

mit $b = \int i(t)dt$, $c = Korrekturfaktor(Phasenwinkel)$ berechnet wird, aus der sich Werte ergeben, welche ein Maß für den obengenannten Effektivwert darstellen, wobei zur Energieverbrauchserfassung über die Dimmerlogik (4) eine Strommessung an dem aktuell fließenden Strom vorgenommen wird und für einen Anwender abrufbar gespeichert und/oder angezeigt wird.

2. Verfahren nach Anspruch 1, **dadurch gekennzeichnet, dass** der aktuelle Stromverbrauch des Verbrauchers (2) aus dem den aktuell eingestellten Dimmwert entsprechenden Stromfluss innerhalb einer Sinushalbwelle der Stromversorgung (3) und der Lasthöhe des Verbrauchers (2) ermittelt wird.

3. Verfahren nach Anspruch 1 oder 2, **dadurch gekennzeichnet, dass** zur Erfassung des Energieverbrauches des elektrischen Verbrauchers (2) der aktuelle Energieverbrauch nur nach jeder Änderung in der Einstellung des Dimmwertes bestimmt wird.

4. Verfahren nach einem der Ansprüche 1 bis 3, **dadurch gekennzeichnet, dass** der Dimmer (1) über eine drahtlose Kommunikation in ein lokales Datennetzwerk eingebunden ist und von dem Dimmer (1) bei einer gewünschten Energieverbrauchserfassung der Dimmwert über das Datennetzwerk an eine in das Datennetzwerk eingebundene, die Ermittlung des Energieverbrauchs vornehmende Auswerteeinrichtung (6) übermittelt wird.

5. Verfahren nach Anspruch 1, **dadurch gekennzeichnet, dass** zur Energieverbrauchserfassung über die Dimmerlogik (4) eine Strommessung an dem aktuell fließenden Strom vorgenommen wird.

6. Verfahren nach Anspruch 5, **dadurch gekennzeichnet, dass** die Strommessung über den ohnehin dimmerseitig vorhandenen A/D-Wandler vorgenommen wird.

7. Verfahren nach Anspruch 6, **dadurch gekennzeichnet, dass** die Strommessung in einer vorgegebenen Frequenz über eine vorgegebene Zeitspanne durchgeführt und aus den aufsummierten Ergebnissen der auf die Zeitspanne bezogene Energieverbrauch ermittelt wird.

8. Verfahren nach Anspruch 7, **dadurch gekennzeichnet, dass** durch einen dimmerseitig vorhandenen Spannungsteiler (R2, R3) der Gleichspannungspegel für die Zwecke der Strommessung angehoben wird, damit durch einen mit einer positiven Betriebsspannung betriebenen Mikrocontroller positive und negative Ströme messbar sind.

9. Verfahren nach einem der Ansprüche 5 bis 8, **dadurch gekennzeichnet, dass** eine Strommessung an einzelnen Punkten einer Netzhalbwelle erfolgt, um anhand dieser einzelnen Strommessergebnisse den Stromfluss der gesamten Halbwelle zu ermitteln.

10. Verfahren nach einem der Ansprüche 5 bis 9, **dadurch gekennzeichnet, dass** die aktuelle Energie einer Halbwelle gespeichert wird, dass nach dem Stromfluss einer Halbwelle die gespeicherte Spannung gemessen und mit einer Nulllage verrechnet wird und dass anschließend aus diesem Wert unter Einbeziehung von Umrechnungsfaktoren der aktuelle Energieverbrauch ermittelt wird.

11. Verfahren nach Anspruch 10, **dadurch gekennzeichnet, dass** die Energie einer Halbwelle in einem Kondensator gespeichert wird.

12. Verfahren nach Anspruch 11, **dadurch gekennzeichnet, dass** der Kondensator nach erfolgter Spannungsmessung entladen wird.

13. Verfahren nach einem der Ansprüche 5 bis 12, **dadurch gekennzeichnet, dass** zusätzlich zu der Strommessung eine Spannungsmessung vorgenommen wird.

14. Verfahren nach einem der Ansprüche 5 bis 13, **dadurch gekennzeichnet, dass** der Dimmer (1) über eine drahtlose Kommunikation in ein lokales Datennetzwerk eingebunden ist und von dem Dimmer die erfassten Strom- und/oder Spannungsmessdaten über das Datennetzwerk an eine in das Datennetzwerk eingebundene, die Ermittlungen des Energieverbrauches vornehmende Auswerteeinrichtung (6) übermittelt wird.

15. Verfahren nach einem der Ansprüche 1 bis 14, **dadurch gekennzeichnet, dass** der Energieverbrauch über die Zeit erfasst wird.

**Claims**

1. Method for detecting the energy consumption of an electrical consumer (2) controlled via a leading-edge or trailing-edge phase dimmer (1), **characterized by the fact** that the current energy consumption of the electrical consumer (2) is determined on the basis of an effective value of the current flow within a sinusoidal half-wave which acts on the electrical consumer (2), in that a correction function is calculated as a function of the electrical consumer using the following formula

$$\frac{\frac{b}{1-\left(\frac{c}{100}\right)}}{\sqrt{2}}$$

mit $b = \int i(t)dt$, $c = Korrekturfaktor(Phasenwinkel)$ from which values result which represent a measure for the above-mentioned effective value, wherein for the purpose of recording energy consumption, a current measurement of the current actually flowing is effected via the dimmer logic (4) and is stored and/or displayed for a user to be recalled.

2. Method in accordance with Claim 1, **characterized by the fact** that the actual current consumption of the consumer (2) is determined by the current flow corresponding to the currently set dimming value within a sinusoidal half-wave of the power supply (3) and the load level of the consumer (2).

3. Method in accordance with Claim 1 or 2, **characterized by the fact** that, in order to record the energy consumption of the electrical consumer (2), the current energy consumption is determined only after each change in the setting of the dimming value.

4. Method in accordance with any of Claims 1 to 3, **characterized by the fact** that the dimmer (1) is integrated into a local data network via wireless communication, and the dimming value is transmitted by the dimmer (1) via the data network to an evaluation device (6) which is integrated into the data network and carries out the determination of the energy consumption when energy consumption is desired.

5. Method in accordance with Claim 1, **characterised by the fact** that for the purpose of detecting energy consumption via the dimmer logic (4) a current measurement is carried out of the current actually flowing.

6. Method in accordance with Claim 5, **characterized by the fact** that the current measurement is carried out via the A/D converter which is present on the dimmer side anyway.

7. Method in accordance with Claim 6, **characterized by the fact** that the current measurement is carried out at a predetermined frequency over a predetermined period of time, and the energy consumption related to the period of time is determined from the summed up results.

8. Method in accordance with Claim 7, **characterized by the fact** that the DC voltage level is raised by a voltage divider (R2, R3) present on the dimmer side for the purposes of current measurement so that positive and negative currents can be measured by a microcontroller operating with a positive operating voltage.

9. Method in accordance with any of Claims 5 to 8, **characterized by the fact** that a current measurement is carried out at individual points of a mains half-wave in order to determine the current flow of the entire half-wave using these individual current measurement results.

10. Method in accordance with any of Claims 5 to 9, **characterized by the fact** that the current energy of a half-wave is stored, that after the current flow of a half-wave the stored voltage is measured and offset against a zero position and that subsequently the current energy consumption is determined from this value including conversion factors.

11. Method in accordance with Claim 10, **characterized by the fact** that the energy of a half-wave is stored in a capacitor.

12. Method in accordance with Claim 11, **characterized by the fact** that the capacitor is discharged after the voltage measurement has been carried out.

13. Method in accordance with any of Claims 5 to 12, **characterized by the fact** that a voltage measurement is carried out in addition to the current measurement.

14. Method in accordance with any of Claims 5 to 13, **characterized by the fact** that the dimmer (1) is integrated into a local data network via wireless communication and the dimmer transmits the detected current and/or voltage measurement data via the data network to an evaluation device (6) which is integrated into the data network and determines the energy consumption.

15. Method in accordance with any of Claims 1 to 14, **characterized by the fact** that the energy consumption is recorded over time.

## Revendications

1. Procédé de détection de la consommation d'énergie d'un consommateur électrique (2) commandée par l'intermédiaire d'un variateur à coupure de phase ascendante ou descendant (1), **caractérisé en ce que** la consommation d'énergie actuelle du consommateur électrique (2) est déterminée sur la base d'une valeur effective du flux de courant à l'intérieur d'une demi-onde sinusoïdale qui agit sur le consommateur électrique (2), **en ce qu'**une fonction de correction est déterminée en fonction du consommateur électrique calculée à l'aide de la formule suivante

$$\frac{\frac{b}{1-\left(\frac{c}{100}\right)}}{\sqrt{2}}$$

*mit b = ∫ i(t)dt, c = Korrekturfaktor(Phasenwinkel)* d'où résultent des valeurs qui représentent une mesure pour la valeur effective susmentionnée, une mesure du courant circulant étant effectuée dans la logique du variateur (4) aux fins de l'enregistrement de la consommation d'énergie et étant mémorisée et/ou affichée pour qu'un utilisateur puisse la rappeler.

**2.** Procédé selon la revendication 1, **caractérisée en ce que** la consommation actuelle de courant du consommateur (2) est déterminée à partir du flux de courant dans une demi-onde sinusoïdale de l'alimentation électrique (3) correspondant à la valeur de gradation actuellement réglée et du niveau de charge du consommateur (2).

**3.** Procédé selon la revendication 1 ou 2, **caractérisé en ce que,** pour enregistrer la consommation d'énergie du consommateur électrique (2), la consommation d'énergie actuelle est déterminée uniquement après chaque modification du réglage de la valeur de gradation.

**4.** Procédé selon l'une des revendications 1 à 3, **caractérisé en ce que** le gradateur (1) est intégré dans un réseau de données local via une communication sans fil et, lorsqu'une détection de consommation d'énergie est souhaitée, la valeur de gradation est transmise par le gradateur (1) via le réseau de données à un dispositif d'évaluation (6) qui est intégré dans le réseau de données et qui effectue la détermination de la consommation d'énergie.

**5.** Procédé selon la revendication 1, **caractérisé en ce que** pour détecter la consommation d'énergie via la logique du gradateur (4), une mesure de courant est effectuée sur le courant qui circule actuellement.

**6.** Procédé selon la revendication 5, **caractérisé en ce que** la mesure du courant est effectuée via le convertisseur A/C qui est de toute façon présent du côté du gradateur.

**7.** Procédé selon la revendication 6, **caractérisé en ce que** la mesure du courant est effectuée à une fréquence prédéterminée pendant une période de temps prédéterminée et la consommation d'énergie liée à la période de temps est déterminée à partir des résultats additionnés.

**8.** Procédé selon la revendication 7, **caractérisé en ce que** le niveau de tension continue est augmenté par un diviseur de tension (R2, R3) présent du côté du gradateur pour la mesure du courant, de sorte que les courants positifs et négatifs peuvent être mesurés par un microcontrôleur fonctionnant avec une tension d'alimentation positive.

**9.** Procédé selon l'une des revendications 5 à 8, **caractérisé en ce qu'**une mesure de courant est effectuée en des points individuels d'une demi-onde de réseau afin de déterminer le flux de courant de l'ensemble de la demi-onde sur la base de ces résultats individuels de mesure de courant.

**10.** Procédé selon l'une des revendications 5 à 9, **caractérisé en ce que** l'énergie actuelle d'une demi-onde est stockée, **en ce qu'**après le passage du courant d'une demi-onde, la tension stockée est mesurée et calculée avec une position zéro, et **en ce qu'**ensuite la consommation d'énergie actuelle est déterminée à partir de cette valeur en incluant des facteurs de conversion.

**11.** Procédé selon la revendication 10, **caractérisé en ce que** l'énergie d'une demi-onde est stockée dans un condensateur.

**12.** Procédé selon la revendication 11, **caractérisé en ce que** le condensateur est déchargé après que la mesure de la tension ait été effectuée.

**13.** Procédé selon l'une des revendications 5 à 12, **caractérisé en ce qu'**une mesure de la tension est effectuée en plus de la mesure du courant.

**14.** Procédé selon l'une des revendications 5 à 13, **caractérisé en ce que** le gradateur (1) est intégré dans un réseau de données local par une communication sans fil et le gradateur transmet les données de mesure de courant et/ou de tension détectées par le réseau de données à un dispositif d'évaluation (6) qui est intégré dans le réseau de données et qui effectue la détermination de la consommation d'énergie.

**15.** Procédé selon l'une des revendications 1 à 14, **caractérisé en ce que** la consommation d'énergie est enregistrée dans le temps.

**Fig. 1**

EP 3 309 560 B1

*Fig. 2*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140081474 A1
- US 20110153246 A1